(19) Europäisches Patentamt
European Patent Office
Office européen des brevets

(11) EP 1 264 214 B1

(12) **EUROPEAN PATENT SPECIFICATION**

(45) Date of publication and mention of the grant of the patent:
**03.11.2004 Bulletin 2004/45**

(21) Application number: **01907265.1**

(22) Date of filing: **14.02.2001**

(51) Int Cl.[7]: **G03F 7/00**, G03F 7/031, G02B 5/32, C09K 19/54

(86) International application number:
**PCT/CA2001/000163**

(87) International publication number:
**WO 2001/059521 (16.08.2001 Gazette 2001/33)**

(54) **PHOTOPOLYMERIZABLE COMPOSITION SENSITIVE TO LIGHT IN A GREEN TO INFRARED REGION OF THE OPTICAL SPECTRUM**

FOTOPOLYMERISIERBARE ZUSAMMENSETZUNG MIT EMPFINDLICHKEIT IM GRÜNEN ZU INFRAROTEN SPEKTRALBEREICH

COMPOSITIONS PHOTOPOLYMERISABLES PHOTOSENSIBLES DANS UNE REGION DU VERT A L'INFRAROUGE DU SPECTRE OPTIQUE

(84) Designated Contracting States:
**AT BE CH CY DE DK ES FI FR GB GR IE IT LI LU MC NL PT SE TR**

(30) Priority: **14.02.2000 CA 2298354**

(43) Date of publication of application:
**11.12.2002 Bulletin 2002/50**

(73) Proprietor: **UNIVERSITE LAVAL
Québec, Québec G1K 7P4 (CA)**

(72) Inventors:
- **GALSTIAN, Tigran
Ste-Foy, Québec G1V 2W1 (CA)**
- **TORK, Amir
Cap-Rouge, Québec G1Y 2H5 (CA)**

(74) Representative: **Casalonga, Axel et al
BUREAU D.A. CASALONGA - JOSSE
Paul-Heyse-Strasse 33
80336 München (DE)**

(56) References cited:
**EP-A- 0 269 397
EP-A- 0 323 563
EP-A- 0 424 866
WO-A-98/46196
US-A- 5 849 270**

- **PILOT P ET AL: "ANGULAR SELECTIVITY OF HOLOGRAPHIC POLYMER DISPERSED LIQUID CRYSTALMATERIALS WITH NEAR IR SENSITIVITY" PROCEEDINGS OF THE SPIE, SPIE, BELLINGHAM, VA, US, vol. 3638, 26 January 1999 (1999-01-26), pages 26-34, XP001015234**
- **PILOT P ET AL: "Near IR (800-855nm) sensitive holographic photopolymer dispersed liquid crystal materials" PROCEEDINGS OF THE SPIE, SPIE, BELLINGHAM, VA, US, vol. 3635, 1999, pages 143-150, XP001032884**
- **NOIRET N ET AL: "PHOTOPOLYMERS FOR HOLOGRAPHIC RECORDING: V. SELF-PROCESSING SYSTEMSWITH NEAR INFRARED SENSITIVITY" PURE AND APPLIED OPTICS, BRISTOL, GB, vol. 3, no. 1, 1994, pages 55-71, XP000994604 ISSN: 0963-9659 cited in the application**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).



Printed by Jouve, 75001 PARIS (FR)

## Description

### Technical Field

The present invention relates to a photopolymerizable composition which is sensitive to infrared, near infrared, red and green light and to the use of such a composition for producing various optical devices. The composition of the invention is particularly useful for producing holographic polymer dispersed liquid crystal (H-PDLC) materials and reversible dye doped polymer (RDDP) materials having improved electrical and optical switching characteristics.

### Background Art

Infrared diode sources are largely used in integrated photonic circuits and the list of their applications grows very rapidly. The management of the radiation of these sources requires the fabrication of optical elements such as lenses, interconnects, modulators, etc. Holographic diffractive elements are emerging as very promising for these applications. These include wavelength selective holographic interconnects (1 to N, or M to N), couplers, lenses, mirrors. Today, a new class of holographic polymer dispersed liquid crystal materials (H-PDLCs) is considered to be one of the most viable technologies for the development of reflective color displays, switchable holographic optical elements (such as Bragg gratings for wavelength division multiplexing (WDM) devices), switchable-focus lenses, etc. See for example Crawford et al., "Reflective color LCDs based on H-PDLC and PSCT technologies", *J. Soc. Information Display,* 1996, 5(1); Domash et al., "Electronically switchable waveguide Bragg gratings for WDM routing", 1997 Digest of the IEEE/LEOS Summer Topical Meetings: Vertical-Cavity Lasers/Technologies for a Global Information Infrastructure/ WDM Components Technology; and Domash et al., "Switchable-focus lenses in holographic polymer dispersed liquid crystal", Proceedings of the SPIE - The International Society for Optical Engineering, vol. 2689, (Diffractive and Holographic Optics Technology III, San Jose, CA, USA, 1-2 Feb. 1996.) SPIE-Int. Soc. Opt. Eng, 1996. p.188-94.

Commercially available holographic materials are generally sensitive only in the UV/visible region of the optical spectrum. Thus, the actual fabrication of above-mentioned elements requires an initial recording step, where a UV-visible laser source is used, and then, a further adaptation or adjustment of the obtained element for utilization with near infrared wavelengths (e.g. 800-850 nm or 1300-1500 nm), which are used in local or long distance communication systems. Due to strong astigmatism and divergence of the diode lasers used, this work is difficult and has poor efficiency. It would therefore be highly desirable to provide *in situ* recording of holographic diffractive elements with lasers, which are already integrated in the given photonic circuit, thus providing self-alignment of the photonic circuits. Thus, there is a need to extend the sensitivity of these materials up to communication wavelengths. Namely, for *in situ* holographic recording of optical components with diode lasers operating in the 800 - 855 nm region, among which there are vertical cavity surface emitting lasers (VCSEL), it is important to have H-PDLC materials with suitable holographic characteristics, which include high sensitivity and diffraction efficiency of the recording, low scattering and noise level, and low switching voltage.

Up to now, the sensitivity of the existing H-PDLC materials has been extended up to 790 nm only (Natarajan et al., Report on Photonics West'98, San Jose, January 1998). See also EP 0 223 587; EP 0 387 087; EP 0 389 067; US 4,343,891; Chatterjee et al., *J. Am. Chem. Soc.,* 1990, 112, 6329; Schuster et 1*, Photochem. Photobiol. A: Chem.,* 1992, 65, 191; Chatterjee et al., *J. Am. Chem. Soc.,* 1988, 110, 2326; Cooper et al., *J. Am. Chem. Soc.,* 1963, 85, 1590; and Noiret et al., *Pure and Applied Optics,* 1994, 3(1), 55-71. Imaging applications with low resolution (such as printing plates) were also successfully explored. Some of the materials were the subject of the study for holographic gratings recording and only very low level of performance was achieved (7 % of diffraction efficiency at sensitivity of about 300 - 500 $mJ/cm^2$), as reported in the mentioned Noiret et al. article *supra.* This low level of performance makes such polymers impractical for commercial application. All the above materials still suffer from limitations such as spatial resolution, diffraction efficiency etc.

### Disclosure of the Invention

It is an object of the present invention to provide an efficient photopolymerizable composition that is sensitive to light in a green to infrared region of the optical spectrum and has improved optical switching characteristics.

According to one aspect of the invention, there is provided a photopolymerizable composition sensitive to light in a green to infrared region of the optical spectrum, comprising:

- a photopolymerizable monomer or oligomer, or a mixture thereof, capable of forming a polymer having predetermined optical properties;
- a photoinitiator sensitive to light in the aforesaid spectral region;
- an additive for increasing the refractive index and decreasing the viscosity of the composition; and

- a filler having optical properties selected to contrast with the optical properties of the polymer.

Use is preferably made of an acrylate monomer. A mixture comprising an acrylate monomer and an acrylate oligomer can also be used.

According to a preferred embodiment, the photoinitiator comprises a sensitizer and an initiator, wherein the sensitizer is efficiently excited by the light in the aforesaid region of the optical spectrum to produce an excited sensitizer, and the initiator is efficiently excited by the excited sensitizer to cause initiation of polymerization of the monomer or oligomer, or mixture thereof. The sensitizer preferably comprises a dye absorbing light in the aforesaid spectral region, such as a cyano-compound, for example cyanine. The initiator is preferably an electron donor comprising a heavy atom such as bromine, iodine, boron, iron and the like, for example, $CBr_4$, $CHBr_3$, $CHI_3$, etc.

An optional co-initiator can also be added to the composition. The co-initiator typically has the same role as that of the initiator. Such a co-initiator is preferably a tertiary aromatic amine, for example ethyl dimethyl benzoate, 1-phenylpiperidine, butyl-4-(N-morpholino)benzoate, 4-nitro-N,N-dimethylaniline, 4-(dimethylamino)benzonitrile and the like.

An additive is added to the composition to decrease its viscosity and increase its refractive index. A low viscosity permits the preparation of a homogeneous composition by capillary effect, while an increase in the refractive index allows an increase in the refractive index modulation contrast. The additive must be compatible and miscible with all the components of the composition without creating any interference during polymerization. 2,5-Dibromothiophen and amyl acetate have been found particularly suitable for this purpose.

The filler preferably comprises a liquid crystal, a photochromic reversible dye or a mixture thereof. It is also possible to use other fillers such as mesogens having polar or functional groups. The liquid crystal preferably has a polar group, such as a cyano group, attached to ends of the molecular chain, whereby large droplets of liquid crystal are more efficiently formed in the polymer. Large droplets allow for more efficient optical state switching. Alternatively, it is possible to use ferroelectric liquid crystals, cholesteric liquid crystals, fluorinated liquid crystals and the like.

Examples of suitable photochromic reversible dye materials which may be used include those sold under the trademarks FULGIDE and SPIROPYRAN.

According to a preferred embodiment, the filler is a novel liquid crystal having the general formula (I):

$$XOR_1NR_2R_3 \qquad (I)$$

wherein:

- $R_1$ is a linear or branched alkyl chain having 5 to 14 carbon atoms, optionally containing one or more insaturations;
- $R_2$ and $R_3$ are the same or different and each represent a linear or branched $C_{1-10}$ alkyl, a linear or branched $C_{1-10}$ alkene or a linear or branched $C_{1-10}$ alkyne; and
- X is linking group substituted by at least one polar group, preferably a cyano group.

The role of the linking group X is mainly to act as a support for one or more polar group. Such linking group can be of any kind, as long as it bears at least one polar group and does not interfere with the polymerization.

The above liquid crystal of formula (1) has excellent optical properties. It can be prepared in two simple steps according to the following scheme:

$$XOH + WR_1\ W \rightarrow XOR_1\ W$$

$$XOR_1\ W + HNR_1R_3 \rightarrow XOR_1NR_2R_3$$

wherein W is leaving group.

In a most preferred embodiment, X is a cyano-monosubsituted biphenyl group, $R_1$ is a linear alkyl chain having 7 or 9 carbon atoms, W is a halogen, and $R_2$ and $R_3$ are ethyl.

The above composition can be applied to prototyping and allows the implementation of optical coupling of waveguides as well as the manufacture of optical devices, in particular diffractive and holographic optical devices. Advantageously, such devices can be made using light in the green to infrared region coming from a light source that is already used in the optical device, such as commonly used communications light sources.

According to another aspect of the invention, there is provided a process for producing an optical device,

comprising the steps of:

a) providing an optical element;
b) providing a photopolymerizable composition as defined above;
c) applying a layer of the photopolymerizable composition onto the optical element; and
d) exposing the optical element with the layer of photopolymerizable composition thereon to light in a green to infrared region of the optical spectrum to cause polymerization of the monomer or oligomer, or mixture thereof, and formation of a recording pattern on the optical element, the recording pattern comprising areas having different densities of filler in exposed and unexposed areas of the layer, thereby obtaining an optical device having thereon areas with different optical properties.

In a preferred embodiment, step (d) is followed by a second exposure to the light in the aforesaid spectral region to cause polymerization of any remaining unpolymerized monomer oligomer.
Preferably, step (d) is carried out to ensure that substantially all of the monomer or oligomer has polymerized The recording pattern may represent a diffraction pattern or a diffractive lens. When the recording pattern is a diffraction pattern, the diffractive element of the optical device is preferably switchable between two optical states when placed in a controllable electric field.
The present invention also provides, in a further aspect thereof, a method of optically connecting at least two waveguides of an optical element, comprising the steps of:

a) providing an optical element having at least two waveguides to be optically connected;
b) providing a photopolymerizable composition as defmed above;
c) applying the photopolymerizable composition between the waveguides to be connected; and
d) exposing the waveguides with the photopolymerizable composition therebetween to light in a green to infrared region of the optical spectrum to cause polymerization of the monomer or oligomer, or mixture thereof, thereby forming an optical connection between the waveguides.

Preferably, the light is transmitted during step (d) through at least one of the waveguides.
The photopolymerizable composition of the present invention possesses a sensitivity extending up to communication wavelengths, thus making the composition practical for commercial applications. Some of the advantageous characteristics of the present composition include:

- sensitivity to the illumination from about 500 nm up to 1000 nm;
- suitable holographic characteristics such as:

    a) high diffraction efficiency (e.g. 98% between 514 and 850 nm);
    b) high sensitivity, preferably greater than 100 mJ/cm$^2$;
    c) low scattering and noise level; and
    d) low switching voltage, preferably lower than 100 V;

- optical switching properties in the presence of a photochromic reversible dye; and
- a simple manufacturing process.

## Brief Description of the Drawings

Further features and advantages of the invention will become more readily apparent from the following description of a preferred embodiment, with reference to the accompanying drawings in which:

Figures 1A and 1B and 1C illustrate the microscopic textures observed respectively in a hologram exposed area (Fig. 1A) and a hologram unexposed area (Fig. 1B; after uniform exposition) of a hologram recorded by a diode laser at 850 nm on a H-PDLC material produced according to a preferred embodiment of the invention;
Figure 2 illustrates the diffracted signal strength as a function of exposure time for the H-PDLC material recorded by the diode laser at 850 nm;
Figure 3 illustrates a graph of diffracted signal strength as a function of extended readout exposure time for the H-PDLC material, showing very high temporal and readout stability, recorded by a Ar laser at 514 nm; and
Figure 4 illustrates an exposure set up for *in situ* recording and monitoring of a diffracted pattern on the H-PDLC material.

## Modes for Carrying out the Invention

The preferred embodiment of the present invention offers a new technical solution needed to provide efficient *in situ* recording of highly efficient and switchable holographic elements in the green to infrared region of the optical spectrum. The preferred embodiment is a photopolymerizable composition which comprises a mixture of photopolymerizable acrylate monomer and oligomer, a photoinitiating system including a dye sensitizer excitable by light in the aforesaid spectral region, an initiator and an optional co-initiator, an organic additive for increasing the refractive index and decreasing the viscosity of the composition, and a liquid crystal or reversible dye as a filler.

The resulting recorded holograms have high diffraction efficiency and unexpected wavelength dependence (98% at near infrared, 70% at red and 95% at green regions). Indeed, with a proper choice of the components of the composition, the dispersion of the diffraction efficiency can be managed, that is, making this dependence to be growing or decreasing with the wavelength. In addition, the composition allows the DC field control of the diffraction efficiency, which can provide, e.g., switchable wavelength division multiplexing (WDM) elements. The present material shows monotonous recording kinetics and very high temporal and readout stability (after fixing). The fixing is performed by uniform light illumination and no curing is required, thus increasing the capacity of the *in situ* fabrication of various integrated optical circuits.

The composition of the present invention has great potential since it can be modified depending on the desired performance of the final product. However, the main components remain the same. Preferred ranges of concentrations for each component are:

- photopolymerizable acrylate monomer and oligomer 40 - 80 weight %
- dye sensitizer 0.02 - 1.0 weight %
- initiator 1 - 15 weight %
- co-initiator 0 - 10 weight %
- filler (liquid crystal of reversible dye) 10 - 50 weight %
- organic additive 10 - 40 weight%

Preparation of Composition

The preparation is preferably carried out in two stages to ensure proper solubility conditions and prevent undesirable thermal reactions.

In a first stage, the following four solutions are prepared separately by magnetic stirring at 30-80°C and complemented with ultrasonic processing:

Solution #1: dye sensitizer with liquid acrylate monomer/oligomer,
Solution #2: initiator with liquid acrylate monomer/oligomer;
Solution #3: co-initiator with liquid acrylate monomer/oligomer; and
Solution #4: liquid crystal (or reversible dye) with organic additive.

Mixing is continued until solubilization is complete and the solutions become homogeneous. The magnetic stirring and ultrasonic processing follow each other and each conducted for about 30 minutes, with the exception of solution #4 which is obtained at room temperature after magnetic stirring for 10 minutes. The solutions thus obtained are cooled down to and stored at room temperature for the second stage.

As a specific example, the following solutions were prepared:

Solution #1: 0.5 to 7 weight % of IR140™ in DPEPA;
Solution #2: 19 weight % of $CBr_4$ in DPEPA;
Solution #3: 12 weight % of EDMABzt in DPEPA;
Solution #4: 1.5 to 3 weight % of Fulgide™ or Spiropyran™ in 2,5-dibromothiophen or amyl acetate solution

wherein
IR140™ is cyanine dye (Aldrich); DPEPA is di-penta-erithrithol-penta-acrylate (Sartomer Company); EDMABzt is ethyl-dimethyl-amino-benzoate (Aldrich); Fulgide™ is 2-(1-(2,5-dimethyl-3-furyl)ethylidene)-3-(2-adamantylidene) succinic anhydride (Aberchrome); and Spiropyran™ is 1',3',3'-trimethylspiro-8-nitro-2H-1-benzopyran-2',2'-indoline (Acros).

In the second stage, the solutions are mixed together at room temperature and in the dark. The resulting solution which constitutes the desired photopolymerizable composition can be used *per se* without any filtration.

Examples of components which may be used in the preparation of the desired composition include:

- as acrylate monomer/oligomer: DPEPA, 2-ethoxy-ethoxy-ethyl acrylate ester, urethane acrylate CN975™ and the like;
- as cyanine dye: IR-140™, IR-132™, IR-143™, IR-786™ and the like (Aldrich);
- as initiator, i.e. heavy atom (preferably Br, B, I or Fe) -containing compound: $CBr_4$, $CHBr_3$, $CHI_3$, and the like;
- as co-initiator: EDMABzt; and
- as liquid crystal compound: E7™, MBBA™ (Merck) and the like.

MBBA™ is also known as N-(p-methoxybenzylidene)-p-butylaniline.

Sample Preparation

A layer of the above-prepared composition is disposed between two slides. A conducting coating, for example, a transparent indium tin oxide coating, can be created on the slides for electric switching operation. The thickness of the layer is defined by spacers, for example, made of Mylar™ film.

Exposure of Sample

Exposure of the sample is carried out in the set up represented in Figure 4. A laser 2 is used as an *in situ* recording source. The laser should be capable of emitting light at various wavelengths in the green to infrared region, i.e., between 500 and 1000 nm. For the purposes of illustrating the present invention, wavelengths of 514,632.8 and 790-855 nm were used. The laser light is focused into a beam by lenses 4 and 6 and pinhole 8, which is directed to beamsplitter 10. The first split beam is directed to mirror 12 and then onto the cell 14 comprising the aforementioned two slides 16 with a layer 18 of photopolymerizable composition therebetween, while the second split beam is directed to mirror 20 and then onto cell 14. The readout wavelength from laser 22 is chosen to be 514 nm to ensure nondestructive monitoring of the recording process. Monitoring is carried out using a photodetector 24 and a computer 26. After recording, the sample is subjected to a stability test, which consists of a uniform exposure to one of the recording beams. This uniform exposure to the recording beam leads to full polymerization in all areas, whether exposed and non-exposed. If the hologram is stable, such an exposure would fix the created modulation of the refractive index. Alternatively, i.e. if the hologram is unstable, such an exposure would lead to partial or complete erasure of the hologram.

The following non-limiting examples further illustrate the invention.

EXAMPLE 1

A liquid crystal of formula (I') hereinbelow was prepared according to the following scheme:

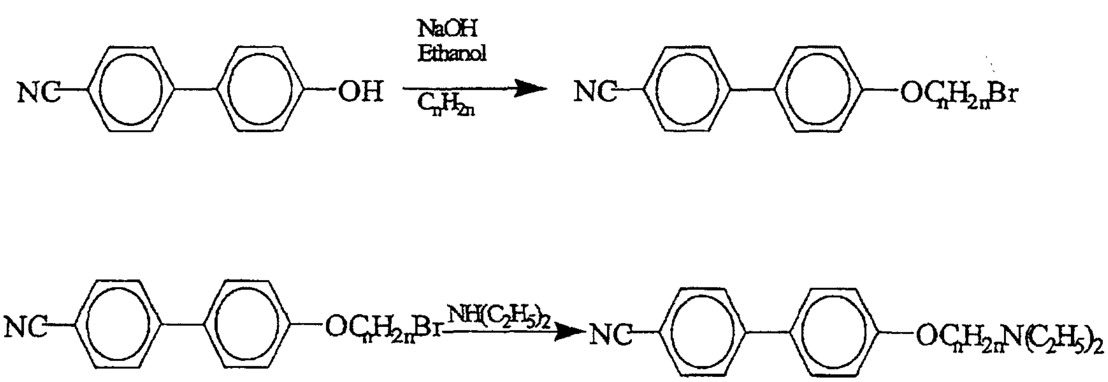


(I')

where n = 7 or 9.

In a first step, purified 4-hydroxy-4'-cyanobiphenyl is dissolved in ethanol (99.5%), to which a molar equivalent of $K_2CO_3$ (stoichiometry ratio) is added. The solution is heated to 75°C for 30 minutes, then an excess of a α,ω-dibromoalkane derivative is added and the solution is stirred and refluxed for 6 h. During refluxing, a dark-yellow precipitate is obtained. The precipitate is collected, washed twice with ethanol (99.5 %), and recrystallized from ethanol, giving the product 4-cyano-4'-bromoalkoxy biphenyl.

In a second step, the bromoalkoxy derivative is dissolved in chloroform, and the solution is heated to 45°C, and then a tenfold excess of diethylamine is added. This solution is stirred at 60°C for 12 h. The product is obtained by evaporating the chloroform and excess diethylamine. It is then redissolved in 25 ml of chloroform, washed 3 times with basic water (1M aq. NaOH), and then three times with distilled water. Recrystallizing once from ethanol/propanol (70/30 v/v) and the column chromatography using the mixed solvent, hexane/chloroform (70/30, v/v), purified the final product 4-cyano-4'-aminoalkoxy biphenyl. The purified product, a brown-yellow viscose liquid, is then dried in vacuum at 45°C for three days. The yield for the product is 65-75%. NMR $H^1$: δ 1.05 (t, $CH_3$ aliphatic), 1.25 (m, $CH_2$ aliphatic), 1.82 (m, $OCH_2C\underline{H_2}$), 2.45 (t, $NC\underline{H_2}CH_2$), 2.58 (q, $N(C\underline{H_2}CH_3)_2$), 3.99 (t, $OC\underline{H_2}CH_2$), 6.96 (d, aromatic), 7.52 (d, aromatic), 7.64 (m, aromatic).

EXAMPLE 2

According to the procedure described above, the following photopolymerizable composition was prepared for holographic recording by a diode laser at 850 nm:

- liquid crystal of formula (I') 15.00 weight %
- IR-140™ (dye sensitizer) 0.16 weight %
- $CBr_4$ (initiator) 4.58 weight %
- EDMABZ (co-initiator) 3.04 weight %
- DPEPA (monomer) 47.22 weight %
- 2,5-dibromothiophen (organic additive) 30.00 weight %

For a thickness of 30 micrometers and spatial frequency of about 1200 lines/mm, the samples obtained exhibit the following recording parameters:
Diffraction efficiency for p-polarization at $\lambda$= 633 - 850 nm: $\eta$ = 98% (exposition: E = 6.9 mW/$cm^2$)

EXAMPLE 3

According to the procedure described above, the following photopolymerizable composition was prepared for holographic recording by a He-Ne laser at 632.8 nm:

- liquid crystal of formula (I') 2.95 weight %
- IR-140™ (dye sensitizer) 0.57 weight %
- $CBr_4$ (initiator) 2.74 weight %
- EDMABZ (co-initiator) 2.03 weight %
- DPEPA (monomer) 63.84 weight %
- 2,5-dibromothiophen (organic additive) 27.87 weight %

For a thickness of 30 micrometers and spatial frequency of about 1200 lines/mm, the samples obtained exhibit the following recording parameters:
Diffraction efficiency for p-polarization at $\lambda$ = 633 - 850 nm: $\eta$ = 70% (E = 2 mW/$cm^2$)

EXAMPLE 4

According to the procedure described above, the following photopolymerizable composition was prepared for holographic recording by a Ar laser at 514 nm:

- liquid crystal of formula (I') 15.00 weight %
- IR-140™ (dye sensitizer) 0.32 weight %
- $CBr_4$ (initiator) 4.58 weight %
- EDMABZ (co-initiator) 3.04 weight %
- DPEPA (monomer) 47.06 weight %
- 2,5-dibromothiophen (organic additive) 30.00 weight %

For a thickness of 30 micrometers and spatial frequency of about 1200 lines/mm, the samples obtained exhibit the following recording parameters:

- diffraction efficiency for p-polarization at $\lambda$ = 514 - 660 nm: $\eta$ = 95 - 98% (E = 38 mW/$cm^2$);

- diffraction efficiency for p-polarization at $\lambda$ = 514 - 660 nm: $\eta$ = 90% (E = 6mW/cm$^2$).

EXAMPLE 5

According to the procedure described above, the following photopolymerizable composition was prepared for holographic recording by a Ar laser at 514 nm:

- liquid crystal of formula (I') 6.02 weight %
- IR-140™ (dye sensitizer) 0.33 weight %
- EDMABZ (initiator) 2.93 weight %
- DPEPA (monomer) 42.53 weight %
- 2,5-dibromothiophen (organic additive) 48.19 weight %

For a thickness of 30 micrometers and spatial frequency of about 1200 lines/mm, the samples obtained exhibit the following recording parameters: Diffraction efficiency for p-polarization at $\lambda$ = 514 - 660 nm: $\eta$ = 60 % (E = 7.5 mW/cm$^2$)

EXAMPLE 6

According to the procedure described above, the following photopolymerizable composition was prepared for holographic recording by a diode laser at 850 nm:

- Fulgide™ (reversible dye) 1.57 weight %
- IR-140™ (dye sensitizer) 0.28 weight %
- $CBr_4$ (initiator) 7.15 weight %
- EDMABZ (co-initiator) 3.94 weight %
- DPEPA (monomer) 78.37 weight %
- amyl acetate (organic additive) 8.68 weight %

For a thickness of 30 microns and spatial frequency of about 1200 lines/mm, the samples obtained exhibit the following recording parameters: Diffraction efficiency for p-polarization at $\lambda$= 633 - 850 nm: $\eta$ = 70% (E=6.9 mW/cm$^2$)

EXAMPLE 7

According to the procedure described above, the following photopolymerizable composition was prepared for holographic recording by a He-Ne laser at 633 nm:

- Spiropyran™ (reversible dye) 2.95 weight %
- IR-140™ (dye sensitizer) 0.58 weight %
- $CBr_4$ (initiator) 2.75 weight %
- EDMABZ (co-initiator) 2.02 weight %
- DPEPA (monomer) 63.84 weight %
- 2,5-dibromothiophen (organic additive) 27.86 weight %

For a thickness of 30 micrometers and spatial frequency of about 1200 lines/mm, the samples obtained exhibit the following recording parameters:
Diffraction efficiency for p-polarization at $\lambda$= 514 - 850 nm: $\eta$= 70 % (E = 38 mW/cm$^2$).

Monomer modification is also contemplated, as for example 2EEEA, which gives "zero dispersion of diffraction efficiency" of the recording. Another monomer (urethaneacrylate CN975™) gives positive dispersion of diffraction efficiency. Negative dispersion was observed with DPEPA only.

The present invention provides for high efficiency of holographic *in situ* recording with lasers emitting at 500 - 1000 nm. The recorded holograms exhibit extremely high photochemical stability. Readout of the hologram did not show signs of any degradation, and the recorded holographic optical elements are switchable with optical excitation and DC voltage methods.

The photopolymerizable composition according to the invention can be utilized as an optical coupling binder which is photoreacted using light from conventional diodes operating in the green to infrared spectral region. The light for photoreacting can be provided by an external light source or in some cases from the waveguides being coupled.

The photopolymerizable composition can also be applied to non-optical and non-holographic device applications, such as laser controlled prototyping, in which green, red, near infrared or infrared laser light can be used to control photopolymerization in a computer controlled plastic prototype manufacturing device.

## Claims

1. A photopolymerizable composition sensitive to light in a green to infrared region of the optical spectrum, comprising:

   - a photopolymerizable monomer or oligomer, or a mixture thereof, capable of forming a polymer having predetermined optical properties;
   - a photoinitiator sensitive to light in said region;
   - an additive for increasing refractive index and decreasing viscosity of the composition, said additive being selected from the group consisting 2,5-dibromothiophen and amyl acetate; and
   - a filler having optical properties selected to contrast with the optical properties of the polymer.

2. A composition according to claim 1, wherein the monomer is an acrylate monomer.

3. A composition according to claim 1, wherein the oligomer is an acrylate oligomer.

4. A composition according to claim 1, wherein the photoinitiator comprises a sensitizer and an initiator, wherein the sensitizer is efficiently excited by said light to produce an excited sensitizer, and the initiator is efficiently excited by the excited sensitizer to cause initiation of polymerization of the monomer or oligomer, or mixture thereof.

5. A composition according to claim 4, wherein the sensitizer is a dye sensitizer.

6. A composition according to claim 5, wherein the dye sensitizer is a cyano-compound.

7. A composition according to claim 4, wherein the initiator is an electron donor.

8. A composition according to claim 4, wherein the photoinitiator further includes a co-initiator.

9. A composition according to claim 1, wherein the filler comprises a liquid crystal, a photochromic reversible dye or a mixture thereof.

10. A composition according to claim 9, wherein the filler is a liquid crystal.

11. A composition according to claim 10, wherein the liquid crystal has the general formula (I):

$$XOR_1NR_2R_3 \qquad (I)$$

    wherein:

    $R_1$ is a linear or branched alkyl chain having 5 to 14 carbon atoms, optionally containing one or more insaturations;
    $R_2$ and $R_3$ are the same or different and each represent a linear or branched $C_{1-10}$ alkyl, a linear or branched $C_{1-10}$ alkene or a linear or branched $C_{1-10}$ alkyne; and
    X is linking group substituted by at least one polar group.

12. A composition according to claim 11, wherein the filler is a liquid crystal of the formula (I) in which X is a biphenyl group monosubstituted by a cyano group.

13. A composition according to claim 11, wherein the filler is a liquid crystal of the formula (I) in which $R_1$ is a linear alkyl chain having 7 or 9 carbon atoms, and $R_2$ and $R_3$ each represent an ethyl group.

14. A composition according to claim 9, wherein the filler is a photochromic reversible dye.

**15.** A holographic polymer dispersed liquid crystal material obtained by exposing a photopolymerizable composition as defined in claim 10 to light in a green to infrared region of the optical spectrum.

**16.** A reversible dye doped polymer material obtained by exposing a photopolymerizable composition as defined in claim 14 to light in a green to infrared region of the optical spectrum.

**17.** A process for producing an optical device, comprising the steps of:

a) providing an optical element;
b) providing a photopolymerizable composition comprising:

- a photopolymerizable monomer or oligomer, or a mixture thereof, capable of forming a polymer having predetermined optical properties;
- a photoinitiator sensitive to light in a green to infrared region of the optical spectrum;
- an additive for increasing refractive index and decreasing viscosity of the composition said additive being selected from the group consisting 2,5-dibromothiophen and amyl acetate; and
- a filler having optical properties selected to contrast with the optical properties of the polymer,

c) applying a layer of the photopolymerizable composition onto the optical element; and
d) exposing the optical element with the layer of photopolymerizable composition thereon to light in said region to cause polymerization of the monomer or oligomer, or mixture thereof, and formation of a recording pattern on the optical element, the recording pattern comprising areas having different densities of filler in exposed and unexposed areas of the layer, thereby obtaining an optical device having thereon areas with different optical properties.

**18.** A process according to claim 17, wherein the optical element is a diffractive element switchable between a diffractive state and a non-diffractive state.

**19.** A process according to claim 17, wherein the monomer is an acrylate monomer.

**20.** A process according to claim 17, wherein the oligomer is an acrylate oligomer.

**21.** A process according to claim 17, wherein the photoinitiator comprises a sensitizer and an initiator, wherein the sensitizer is efficiently excited by said light to produce an excited sensitizer, and the initiator is efficiently excited by the excited sensitizer to cause initiation of polymerization of the monomer or oligomer, or mixture thereof.

**22.** A process according to claim 21, wherein the sensitizer is a dye sensitizer.

**23.** A process according to claim 22, wherein the dye sensitizer is a cyano-compound.

**24.** A process according to claim 21, wherein the initiator is an electron donor.

**25.** A process according to claim 21, wherein the photoinitiator further includes a co-initiator.

**26.** A process according to claim 17, wherein the filler comprises a liquid crystal, a photochromic reversible dye or a mixture thereof.

**27.** A process according to claim 26, wherein the filler is a liquid crystal.

**28.** A process according to claim 27, wherein the liquid crystal has the general formula (I):

$$XOR_1NR_2R_3 \quad (I)$$

wherein:

$R_1$ is a linear or branched alkyl chain having 5 to 14 carbon atoms, optionally containing one or more insatu-

rations;
$R_2$ and $R_3$ are the same or different and each represent a linear or branched $C_{1-10}$ alkyl, a linear or branched $C_{1-10}$ alkene or a linear or branched $C_{1-10}$ alkyne; and
X is linking group substituted by at least one polar group.

**29.** A process according to claim 28, wherein the filler is a liquid crystal of the formula (I) in which X is a biphenyl group monosubstituted by a cyano group.

**30.** A process according to claim 28, wherein the filler is a liquid crystal of the formula (I) in which $R_1$ is a linear alkyl chain having 7 or 9 carbon atoms, and $R_2$ and $R_3$ each represent an ethyl group.

**31.** A process according to claim 26, wherein the filler is a photochromic reversible dye.

**32.** A process according to claim 17, wherein the optical device obtained in step (d) is a diffractive optical device.

**33.** A process according to claim 17, wherein the optical device obtained in step (d) is a holographic optical device.

**34.** A process according to claim 18, wherein step (d) is carried *in situ* from an output of a light source directed by said diffractive element.

**35.** A process according to claim 17, wherein step (d) is followed by a second exposure of said optical element to said light to cause polymerization of any remaining unpolymerized monomer or oligomer.

**36.** A method of optically connecting at least two waveguides of an optical element, comprising the steps of:

a) providing an optical element having at least two waveguides to be optically connected
b) providing a photopolymerizable composition comprising:

- a photopolymerizable monomer or oligomer, or a mixture thereof, capable of forming a polymer having predetermined optical properties;
- a photoinitiator sensitive to light in a green to infrared region of the optical spectrum;
- an additive for increasing refractive index and decreasing viscosity of the composition; and
- a filler having optical properties selected to contrast with the optical properties of the polymer,

c) applying the photopolymerizable composition between the waveguides to be connected; and
d) exposing the waveguides with the photopolymerizable composition therebetween to light in said region to cause polymerization of the monomer or oligomer, or mixture thereof, thereby forming an optical connection between the waveguides.

**37.** A method according to claim 36, wherein the monomer is an acrylate monomer.

**38.** A method according to claim 36, wherein the oligomer is an acrylate oligomer.

**39.** A method according to claim 36, wherein the photoinitiator comprises a sensitizer and an initiator, wherein the sensitizer is efficiently excited by said light to produce an excited sensitizer, and the initiator is efficiently excited by the excited sensitizer to cause initiation of polymerization of the monomer or oligomer, or mixture thereof.

**40.** A method according to claim 39, wherein the sensitizer is a dye sensitizer.

**41.** A method according to claim 40, wherein the dye sensitizer is a cyano-compound.

**42.** A method according to claim 39, wherein the initiator is an electron donor.

**43.** A method according to claim 39, wherein the photoinitiator further includes a co-initiator.

**44.** A method according to claim 36, wherein the filler comprises a liquid crystal, a photochromic reversible dye or a mixture thereof.

**45.** A method according to claim 44, wherein the filler is a liquid crystal.

**46.** A method according to claim 45, wherein the liquid crystal has the general formula (I):

$$XOR_1NR_2R_3 \quad (I)$$

wherein:

$R_1$ is a linear or branched alkyl chain having 5 to 14 carbon atoms, optionally containing one or more insaturations;
$R_2$ and $R_3$ are the same or different and each represent a linear or branched $C_{1-10}$ alkyl, a linear or branched $C_{1-10}$ alkene or a linear or branched $C_{1-10}$ alkyne; and
X is linking group substituted by at least one polar group.

**47.** A method according to claim 46, wherein the filler is a liquid crystal of the formula (I) in which X is a biphenyl group monosubstituted by a cyano group.

**48.** A method according to 46, wherein the filler is a liquid crystal of the formula (I) in which $R_1$ is a linear alkyl chain having 7 or 9 carbon atoms, and $R_2$ and $R_3$ each represent an ethyl group.

**49.** A method according to claim 44, wherein the filler is a photochromic reversible dye.

**50.** A method according to claim 36, wherein in step (d) said light is transmitted through at least one of said waveguides.

**Patentansprüche**

**1.** Photopolymerisierbare Zusammensetzung, die für Licht in einem Grün- bis Infrarotbereich des optischen Spektrums empfindlich ist, umfassend:

- ein photopolymerisierbares Monomer oder Oligomer oder eine Mischung davon, mit der Fähigkeit, ein Polymer vorbestimmter optischer Eigenschaften zu bilden;

- einen Photoinitiator, der für Licht in dem Bereich empfindlich ist;

- einen Zusatzstoff zum Erhöhen des Brechungsindexes und zum Senken der Viskosität der Zusammensetzung, wobei der Zusatzstoff ausgewählt ist aus der Gruppe bestehend aus 2,5-Dibromothiophen und Amylacetat; und

- ein Füllmittel mit optischen Eigenschaften, die so gewählt sind, dass sie in Kontrast zu den optischen Eigenschaften des Polymers stehen.

**2.** Zusammensetzung gemäß Anspruch 1, wobei das Monomer ein Acrylatmonomer ist.

**3.** Zusammensetzung gemäß Anspruch 1, wobei das Oligomer ein Acrylatoligomer ist.

**4.** Zusammensetzung gemäß Anspruch 1, wobei der Photoinitiator einen Sensibilisator und einen Initiator umfasst, wobei der Sensibilisator wirksam durch das Licht angeregt wird, um einen angeregten Sensibilisator zu erzeugen, und der Initiator wirksam durch den angeregten Sensibilisator angeregt wird, um eine Initiierung der Polymerisation des Monomers oder Oligomers oder der Mischung davon zu bewirken.

**5.** Zusammensetzung gemäß Anspruch 4, wobei der Sensibilisator ein Farbstoffsensibilisator ist.

**6.** Zusammensetzung gemäß Anspruch 5, wobei der Farbstoffsensibilisator eine Cyanverbindung ist.

**7.** Zusammensetzung gemäß Anspruch 4, wobei der Initiator ein Elektronenspender ist.

**8.** Zusammensetzung gemäß Anspruch 4, wobei der Photoinitiator des Weiteren einen Coinitiator enthält.

**9.** Zusammensetzung gemäß Anspruch 1, wobei das Füllmittel einen Flüssigkristall, einen photochromen reversiblen Farbstoff oder eine Mischung davon umfasst.

**10.** Zusammensetzung gemäß Anspruch 9, wobei das Füllmittel ein Flüssigkristall ist.

**11.** Zusammensetzung gemäß Anspruch 10, wobei der Flüssigkristall die allgemeine Formel (I) hat:

$$XOR_1NR_2R_3 \qquad (I)$$

wobei:

$R_1$ eine lineare oder verzweigte Alkylkette mit 5 bis 14 Kohlenstoffatomen ist, die wahlweise eine oder mehrere Ungesättigtheiten enthält;

$R_2$ und $R_3$ gleich oder verschieden sind und jeweils ein lineares oder verzweigtes $C_{1-10}$-Alkyl, ein lineares oder verzweigtes $C_{1-10}$-Alken oder ein lineares oder verzweigtes $C_{1-10}$-Alkyn darstellen; und

X eine Verbindungsgruppe ist, die durch mindestens eine polare Gruppe substituiert ist.

**12.** Zusammensetzung gemäß Anspruch 11, wobei das Füllmittel ein Flüssigkristall der Formel (I) ist, wobei X eine Biphenylgruppe ist, die durch eine Cyangruppe monosubstituiert ist.

**13.** Zusammensetzung gemäß Anspruch 11, wobei das Füllmittel ein Flüssigkristall der Formel (I) ist, wobei $R_1$ eine lineare Alkylkette mit 7 oder 9 Kohlenstoffatomen ist und $R_2$ und $R_3$ jeweils eine Ethylgruppe darstellen.

**14.** Zusammensetzung gemäß Anspruch 9, wobei das Füllmittel ein photochromer reversibler Farbstoff ist.

**15.** Holographisches Polymer Dispersed Liquid Crystal (PDLC), das durch Bestrahlen einer photopolymerisierbaren Zusammensetzung gemäß Anspruch 10 mit Licht in einem Grün- bis Infratorbereich des optischen Spektrums erhalten wird.

**16.** Mit reversiblem Farbstoff dotiertes Polymermaterial, das durch Bestrahlen einer photopolymerisierbaren Zusammensetzung gemäß Anspruch 14 mit Licht in einem Grün- bis Infratorbereich des optischen Spektrums erhalten wird.

**17.** Verfahren zur Herstellung einer optischen Vorrichtung, umfassend die folgenden Schritte:

a) Bereitstellen eines optischen Elements;

b) Bereitstellen einer photopolymerisierbaren Zusammensetzung, umfassend:

- einen photopolymerisierbares Monomer oder Oligomer oder eine Mischung davon, mit der Fähigkeit, ein Polymer vorbestimmter optischer Eigenschaften zu bilden;
- ein Photoinitiator, der für Licht im Grün- bis Infrarotbereich des optischen Spektrums empfindlich ist;
- einen Zusatzstoff zum Erhöhen des Brechungsindexes und zum Senken der Viskosität der Zusammensetzung,

wobei der Zusatzstoff ausgewählt ist aus der Gruppe bestehend aus 2,5-Dibromothiophen und Amylacetat; und

- ein Füllmittel mit optischen Eigenschaften, die so gewählt sind, dass sie in Kontrast zu den optischen Eigenschaften des Polymers stehen;

c) Auftragen einer Schicht der photopolymerisierbaren Zusammensetzung auf das optisch Element; und

d) Bestrahlen des optischen Elements mit der darauf befindlichen photopolymerisierbaren Zusammensetzung mit Licht in dem Bereich, um eine Polymerisation des Monomers oder Oligomers oder der Mischung davon zu bewirken, und Bilden eines Aufzeichnungsmusters auf dem optischen Element, wobei das Aufzeichnungsmuster Flächen mit verschiedenen Füllmitteldichten in bestrahlten und unbestrahlten Flächen der Schicht umfasst, wodurch eine optische Vorrichtung erhalten wird, die Flächen mit unterschiedlichen optischen Eigenschaften aufweist.

**18.** Verfahren gemäß Anspruch 17, wobei das optische Element ein beugendes Element ist, das zwischen einem beugenden Zustand und einem nicht beugenden Zustand umgeschaltet werden kann.

**19.** Verfahren gemäß Anspruch 17, wobei das Monomer ein Acrylatmonomer ist.

**20.** Verfahren gemäß Anspruch 17, wobei das Oligomer ein Acrylatoligomer ist.

**21.** Verfahren gemäß Anspruch 17, wobei der Photoinitiator einen Sensibilisator und einen Initiator umfasst, wobei der Sensibilisator wirksam durch das Licht angeregt wird, um einen angeregten Sensibilisator zu erzeugen, und der Initiator wirksam durch den angeregten Sensibilisator angeregt wird, um eine Initiierung der Polymerisation des Monomers oder Oligomers oder der Mischung davon zu bewirken.

**22.** Verfahren gemäß Anspruch 21, wobei der Sensibilisator ein Farbstoffsensibilisator ist.

**23.** Verfahren gemäß Anspruch 22, wobei der Farbstoffsensibilisator eine Cyanverbindung ist.

**24.** Verfahren gemäß Anspruch 21, wobei der Initiator ein Elektronenspender ist.

**25.** Verfahren gemäß Anspruch 21, wobei der Photoinitiator des Weiteren einen Coinitiator enthält.

**26.** Verfahren gemäß Anspruch 17, wobei das Füllmittel einen Flüssigkristall, einen photochromen reversiblen Farbstoff oder eine Mischung davon umfasst.

**27.** Verfahren gemäß Anspruch 26, wobei das Füllmittel ein Flüssigkristall ist.

**28.** Verfahren gemäß Anspruch 27, wobei der Flüssigkristall die allgemeine Formel (I) hat:

$$XOR_1NR_2R_3 \qquad (I)$$

wobei:

$R_1$ eine lineare oder verzweigte Alkylkette mit 5 bis 14 Kohlenstoffatomen ist, die wahlweise eine oder mehrere Ungesättigtheiten enthält;

$R_2$ und $R_3$ gleich oder verschieden sind und jeweils ein lineares oder verzweigtes $C_{1-10}$-Alkyl, ein lineares oder verzweigtes $C_{1-10}$-Alken oder ein lineares oder verzweigtes $C_{1-10}$-Alkyn darstellen; und

X eine Verbindungsgruppe ist, die durch mindestens eine polare Gruppe substituiert ist.

**29.** Verfahren gemäß Anspruch 28, wobei das Füllmittel ein Flüssigkristall der Formel (I) ist, wobei X eine Biphenylgruppe ist, die durch eine Cyangruppe monosubstituiert ist.

**30.** Verfahren gemäß Anspruch 28, wobei das Füllmittel ein Flüssigkristall der Formel (I) ist, wobei $R_1$ eine lineare Alkylkette mit 7 oder 9 Kohlenstoffatomen ist und $R_2$ und $R_3$ jeweils eine Ethylgruppe darstellen.

**31.** Verfahren gemäß Anspruch 26, wobei das Füllmittel ein photochromer reversibler Farbstoff ist.

**32.** Verfahren gemäß Anspruch 17, wobei die optische Vorrichtung, die in Schritt (d) erhalten wird, eine beugende optische Vorrichtung ist.

**33.** Verfahren gemäß Anspruch 17, wobei die optische Vorrichtung, die in Schritt (d) erhalten wird, eine holographische optische Vorrichtung ist.

**34.** Verfahren gemäß Anspruch 18, wobei Schritt (d) in situ von einem Ausgang einer Lichtquelle ausgeführt wird, der durch das beugende Element gerichtet ist.

**35.** Verfahren gemäß Anspruch 17, wobei auf Schritt (d) eine zweite Bestrahlung des optischen Elements mit dem Licht erfolgt, um eine Polymerisation jedes verbleibenden unpolymerisierten Monomers oder Oligomers zu bewirken.

**36.** Verfahren zum optischen Verbinden von mindestens zwei Wellenleitern eines optischen Elements, umfassend die folgenden Schritte:

a) Bereitstellen eines optischen Elements mit mindestens zwei Wellenleitern, die optisch zu verbinden sind;

b) Bereitstellen einer photopolymerisierbaren Zusammensetzung, umfassend:

- ein photopolymerisierbares Monomer oder Oligomer oder eine Mischung davon, mit der Fähigkeit, ein Polymer vorbestimmter optischer Eigenschaften zu bilden;
- einen Photoinitiator, der für Licht im Grün- bis Infrarotbereich des optischen Spektrums empfindlich ist;
- einen Zusatzstoff zum Erhöhen des Brechungsindexes und zum Senken der Viskosität der Zusammensetzung; und
- ein Füllmittel mit optischen Eigenschaften, die so gewählt sind, dass sie in Kontrast zu den optischen Eigenschaften des Polymers stehen;

c) Auftragen der photopolymerisierbaren Zusammensetzung zwischen den zu verbindenden Wellenleitern; und

d) Bestrahlen der Wellenleiter mit der dazwischen befindlichen photopolymerisierbaren Zusammensetzung mit Licht in dem Bereich, um eine Polymerisation des Monomers oder Oligomers oder der Mischung davon zu bewirken, wodurch eine optische Verbindung zwischen den Wellenleitern hergestellt wird.

**37.** Verfahren gemäß Anspruch 36, wobei das Monomer ein Acrylatmonomer ist.

**38.** Verfahren gemäß Anspruch 36, wobei das Oligomer ein Acrylatoligomer ist.

**39.** Verfahren gemäß Anspruch 36, wobei der Photoinitiator einen Sensibilisator und einen Initiator umfasst, wobei der Sensibilisator wirksam durch das Licht angeregt wird, um einen angeregten Sensibilisator zu erzeugen, und der Initiator wirksam durch den angeregten Sensibilisator angeregt wird, um eine Initiierung der Polymerisation des Monomers oder Oligomers oder der Mischung davon zu bewirken.

**40.** Verfahren gemäß Anspruch 39, wobei der Sensibilisator ein Farbstoffsensibilisator ist.

**41.** Verfahren gemäß Anspruch 40, wobei der Farbstoffsensibilisator eine Cyanverbindung ist.

**42.** Verfahren gemäß Anspruch 39, wobei der Initiator ein Elektronenspender ist.

**43.** Verfahren gemäß Anspruch 39, wobei der Photoinitiator des Weiteren einen Coinitiator enthält.

**44.** Verfahren gemäß Anspruch 36, wobei das Füllmittel einen Flüssigkristall, einen photochromen reversiblen Farbstoff oder eine Mischung davon umfasst.

**45.** Verfahren gemäß Anspruch 44, wobei das Füllmittel ein Flüssigkristall ist.

**46.** Verfahren gemäß Anspruch 45, wobei der Flüssigkristall die allgemeine Formel (I) hat:

$$XOR_1NR_2R_3 \quad (I)$$

wobei:

$R_1$ eine lineare oder verzweigte Alkylkette mit 5 bis 14 Kohlenstoffatomen ist, die wahlweise eine oder mehrere Ungesättigtheiten enthält;

$R_2$ und $R_3$ gleich oder verschieden sind und jeweils ein lineares oder verzweigtes $C_{1-10}$-Alkyl, ein lineares oder verzweigtes $C_{1-10}$-Alken oder ein lineares oder verzweigtes $C_{1-10}$-Alkyn darstellen; und

X eine Verbindungsgruppe ist, die durch mindestens eine polare Gruppe substituiert ist.

**47.** Verfahren gemäß Anspruch 46, wobei das Füllmittel ein Flüssigkristall der Formel (I) ist, wobei X eine Biphenylgruppe ist, die durch eine Cyangruppe monosubstituiert ist.

**48.** Verfahren gemäß Anspruch 46, wobei das Füllmittel ein Flüssigkristall der Formel (I) ist, wobei $R_1$ eine lineare Alkylkette mit 7 oder 9 Kohlenstoffatomen ist und $R_2$ und $R_3$ jeweils eine Ethylgruppe darstellen.

**49.** Verfahren gemäß Anspruch 44, wobei das Füllmittel ein photochromer reversibler Farbstoff ist.

**50.** Verfahren gemäß Anspruch 36, wobei in Schritt (d) das Licht durch mindestens einen der Wellenleiter geleitet wird.

## Revendications

**1.** Composition photopolymérisable, sensible à une lumière située dans le domaine du spectre optique allant du vert à l'infrarouge, comprenant :

- un monomère ou oligomère photopolymérisable, ou un mélange de tels composés, capable de former un polymère présentant des propriétés optiques prédéterminées ;
- un photoamorceur sensible à une lumière située dans ledit domaine ;
- un adjuvant qui sert à augmenter l'indice de réfraction de la composition et à réduire la viscosité de celle-ci, lequel adjuvant est choisi dans l'ensemble formé par du 2,5-dibromothiophène et de l'acétate d'amyle ;
- et une charge choisie pour que ses propriétés optiques contrastent avec les propriétés optiques du polymère.

**2.** Composition conforme à la revendication 1, dans laquelle le monomère est un monomère de type acrylate.

**3.** Composition conforme à la revendication 1, dans laquelle l'oligomère est un oligomère de type acrylate.

**4.** Composition conforme à la revendication 1, dans laquelle le photoamorceur comprend un sensibilisateur et un amorceur, le sensibilisateur est excité par ladite lumière, ce qui a pour effet de donner un sensibilisateur excité, et l'amorceur est excité par ce sensibilisateur excité, ce qui a pour effet de provoquer l'amorçage de la polymérisation du monomère ou de l'oligomère, ou du mélange de tels composés.

**5.** Composition conforme à la revendication 4, dans laquelle le sensibilisateur est un colorant sensibilisateur.

**6.** Composition conforme à la revendication 5, dans laquelle le colorant sensibilisateur est un composé à groupe cyano.

**7.** Composition conforme à la revendication 4, dans laquelle l'amorceur est un composé donneur d'électrons.

**8.** Composition conforme à la revendication 4, dans laquelle le photoamorceur comprend en outre un co-amorceur.

**9.** Composition conforme à la revendication 1, dans laquelle la charge comprend un cristal liquide, un colorant photochrome réversible, ou un mélange de tels corps.

**10.** Composition conforme à la revendication 9, dans laquelle la charge est un cristal liquide.

**11.** Composition conforme à la revendication 10, dans laquelle le cristal liquide présente la formule générale (I) :

$$XOR_1NR_2R_3 \quad (I)$$

dans laquelle

$R_1$ représente une chaîne alkyle linéaire ou ramifiée, comportant 5 à 14 atomes de carbone et présentant éventuellement une ou plusieurs insaturations,
$R_2$ et $R_3$ représentent la même chose ou des choses différentes, et chacun de ces symboles représente un groupe alkyle en $C_{1-10}$ linéaire ou ramifié, alcényle en $C_{1-10}$ linéaire ou ramifié, ou alcynyle en $C_{1-10}$ linéaire ou ramifié,
et X représente un groupe raccord qui porte au moins un substituant polaire.

**12.** Composition conforme à la revendication 11, dans laquelle la charge est un cristal liquide de formule (I) où X représente un groupe biphényle portant un seul substituant qui est un groupe cyano.

**13.** Composition conforme à la revendication 11, dans laquelle la charge est un cristal liquide de formule (I) où $R_1$ représente un groupe alkyle linéaire ou ramifié, comportant 7 à 9 atomes de carbone, et $R_2$ et $R_3$ représentent chacun un groupe éthyle.

**14.** Composition conforme à la revendication 9, dans laquelle la charge est un colorant photochrome réversible.

**15.** Matériau polymère holographique à cristal liquide dispersé, obtenu par exposition d'une composition photopolymérisable, conforme à la revendication 10, à une lumière située dans le domaine du spectre optique allant du vert à l'infrarouge.

**16.** Matériau polymère dopé par colorant réversible, obtenu par exposition d'une composition photopolymérisable, conforme à la revendication 14, à une lumière située dans le domaine du spectre optique allant du vert à l'infrarouge.

**17.** Procédé permettant de produire un dispositif optique, lequel procédé comporte les étapes suivantes :

a) prendre un élément optique ;
b) prendre une composition photopolymérisable qui comporte :

- un monomère ou oligomère photopolymérisable, ou un mélange de tels composés, capable de former un polymère présentant des propriétés optiques prédéterminées,
- un photoamorceur sensible à une lumière située dans le domaine du spectre optique allant du vert à l'infrarouge,
- un adjuvant qui sert à augmenter l'indice de réfraction de la composition et à réduire la viscosité de celle-ci, lequel adjuvant est choisi dans l'ensemble formé par du 2,5-dibromothiophène et de l'acétate d'amyle,
- et une charge choisie pour que ses propriétés optiques contrastent avec les propriétés optiques du polymère ;

c) appliquer une couche de cette composition photopolymérisable sur l'élément optique ;
d) et exposer cet élément optique, qui porte sur lui ladite couche de composition photopolymérisable, à une lumière située dans ledit domaine, pour provoquer la polymérisation du monomère ou de l'oligomère, ou du mélange de tels composés, et la formation, sur l'élément optique, d'un motif d'enregistrement constitué de zones où les densités de charge sont différentes dans les zones exposées et les zones non-exposées de ladite couche, ce qui donne un dispositif optique portant sur lui des zones présentant des propriétés optiques différentes.

**18.** Procédé conforme à la revendication 17, dans lequel l'élément optique est un élément optique diffractif commutable entre un état diffractif et un état non-diffractif.

**19.** Procédé conforme à la revendication 17, dans lequel le monomère est un monomère de type acrylate.

**20.** Procédé conforme à la revendication 17, dans lequel l'oligomère est un oligomère de type acrylate.

**21.** Procédé conforme à la revendication 17, dans lequel le photoamorceur comprend un sensibilisateur et un amorceur, le sensibilisateur est excité par ladite lumière, ce qui a pour effet de donner un sensibilisateur excité, et l'amorceur est excité par ce sensibilisateur excité, ce qui a pour effet de provoquer l'amorçage de la polymérisation du monomère ou de l'oligomère, ou du mélange de tels composés.

**22.** Procédé conforme à la revendication 21, dans lequel le sensibilisateur est un colorant sensibilisateur.

**23.** Procédé conforme à la revendication 22, dans lequel le colorant sensibilisateur est un composé à groupe cyano.

**24.** Procédé conforme à la revendication 21, dans lequel l'amorceur est un composé donneur d'électrons.

**25.** Procédé conforme à la revendication 21, dans lequel le photoamorceur comprend en outre un co-amorceur.

**26.** Procédé conforme à la revendication 17, dans lequel la charge comprend un cristal liquide, un colorant photochrome réversible, ou un mélange de tels corps.

**27.** Procédé conforme à la revendication 26, dans lequel la charge est un cristal liquide.

**28.** Procédé conforme à la revendication 27, dans lequel le cristal liquide présente la formule générale (I) :

$$XOR_1NR_2R_3 \qquad (I)$$

dans laquelle

$R_1$ représente une chaîne alkyle linéaire ou ramifiée, comportant 5 à 14 atomes de carbone et présentant éventuellement une ou plusieurs insaturations,
$R_2$ et $R_3$ représentent la même chose ou des choses différentes, et chacun de ces symboles représente un groupe alkyle en $C_{1-10}$ linéaire ou ramifié, alcényle en $C_{1-10}$ linéaire ou ramifié, ou alcynyle en $C_{1-10}$ linéaire ou ramifié,
et X représente un groupe raccord qui porte au moins un substituant polaire.

**29.** Procédé conforme à la revendication 28, dans lequel la charge est un cristal liquide de formule (I) où X représente un groupe biphényle portant un seul substituant qui est un groupe cyano.

**30.** Procédé conforme à la revendication 28, dans lequel la charge est un cristal liquide de formule (I) où $R_1$ représente un groupe alkyle linéaire ou ramifié, comportant 7 à 9 atomes de carbone, et $R_2$ et $R_3$ représentent chacun un groupe éthyle.

**31.** Procédé conforme à la revendication 26, dans lequel la charge est un colorant photochrome réversible.

**32.** Procédé conforme à la revendication 17, dans lequel le dispositif optique obtenu dans l'étape (d) est un dispositif optique diffractif.

**33.** Procédé conforme à la revendication 17, dans lequel le dispositif optique obtenu dans l'étape (d) est un dispositif optique holographique.

**34.** Procédé conforme à la revendication 18, dans lequel on effectue l'étape (d) in situ, à l'aide d'une lumière provenant d'une source de lumière et dirigée par ledit élément diffractif.

**35.** Procédé conforme à la revendication 17, dans lequel l'étape (d) est suivie d'une deuxième étape d'exposition dudit élément optique à ladite lumière, dont le but est de faire polymériser tout résidu de monomère ou d'oligomère non polymérisé.

**36.** Procédé permettant d'établir une connexion optique entre au moins deux guides d'onde d'un élément optique, lequel procédé comporte les étapes suivantes :

a) prendre un élément optique comportant au moins deux guides d'onde entre lesquels il faut établir une connexion optique ;
b) prendre une composition photopolymérisable qui comporte :

- un monomère ou oligomère photopolymérisable, ou un mélange de tels composés, capable de former un polymère présentant des propriétés optiques prédéterminées,
- un photoamorceur sensible à une lumière située dans le domaine du spectre optique allant du vert à l'infrarouge,
- un adjuvant qui sert à augmenter l'indice de réfraction de la composition et à réduire la viscosité de celle-ci, lequel adjuvant est choisi dans l'ensemble formé par du 2,5-dibromothiophène et de l'acétate d'amyle,
- et une charge choisie pour que ses propriétés optiques contrastent avec les propriétés optiques du polymère ;

c) appliquer cette composition photopolymérisable entre les guides d'onde à connecter ;
d) et exposer les guides d'onde et la composition photopolymérisable appliquée entre eux à une lumière située dans ledit domaine, pour provoquer la polymérisation du monomère ou de l'oligomère, ou du mélange de tels composés, ce qui permet de former une connexion optique entre les guides d'onde.

**37.** Procédé conforme à la revendication 36, dans lequel le monomère est un monomère de type acrylate.

**38.** Procédé conforme à la revendication 36, dans lequel l'oligomère est un oligomère de type acrylate.

**39.** Procédé conforme à la revendication 36, dans lequel le photoamorceur comprend un sensibilisateur et un amorceur, le sensibilisateur est excité par ladite lumière, ce qui a pour effet de donner un sensibilisateur excité, et l'amorceur est excité par ce sensibilisateur excité, ce qui a pour effet de provoquer l'amorçage de la polymérisation du monomère ou de l'oligomère, ou du mélange de tels composés.

**40.** Procédé conforme à la revendication 39, dans lequel le sensibilisateur est un colorant sensibilisateur.

**41.** Procédé conforme à la revendication 40, dans lequel le colorant sensibilisateur est un composé à groupe cyano.

**42.** Procédé conforme à la revendication 39, dans lequel l'amorceur est un composé donneur d'électrons.

**43.** Procédé conforme à la revendication 39, dans lequel le photoamorceur comprend en outre un co-amorceur.

**44.** Procédé conforme à la revendication 36, dans lequel la charge comprend un cristal liquide, un colorant photochrome réversible, ou un mélange de tels corps.

**45.** Procédé conforme à la revendication 44, dans lequel la charge est un cristal liquide.

**46.** Procédé conforme à la revendication 45, dans lequel le cristal liquide présente la formule générale (I) :

$$XOR_1NR_2R_3 \quad (I)$$

dans laquelle

$R_1$ représente une chaîne alkyle linéaire ou ramifiée, comportant 5 à 14 atomes de carbone et présentant éventuellement une ou plusieurs insaturations,
$R_2$ et $R_3$ représentent la même chose ou des choses différentes, et chacun de ces symboles représente un

groupe alkyle en $C_{1-10}$ linéaire ou ramifié, alcényle en $C_{1-10}$ linéaire ou ramifié, ou alcynyle en $C_{1-10}$ linéaire ou ramifié,
et X représente un groupe raccord qui porte au moins un substituant polaire.

**47.** Procédé conforme à la revendication 46, dans lequel la charge est un cristal liquide de formule (I) où X représente un groupe biphényle portant un seul substituant qui est un groupe cyano.

**48.** Procédé conforme à la revendication 46, dans lequel la charge est un cristal liquide de formule (I) où $R_1$ représente un groupe alkyle linéaire ou ramifié, comportant 7 à 9 atomes de carbone, et $R_2$ et $R_3$ représentent chacun un groupe éthyle.

**49.** Procédé conforme à la revendication 44, dans lequel la charge est un colorant photochrome réversible.

**50.** Procédé conforme à la revendication 36, dans lequel, dans l'étape (d), ladite lumière est transmise à travers au moins l'un desdits guides d'onde.

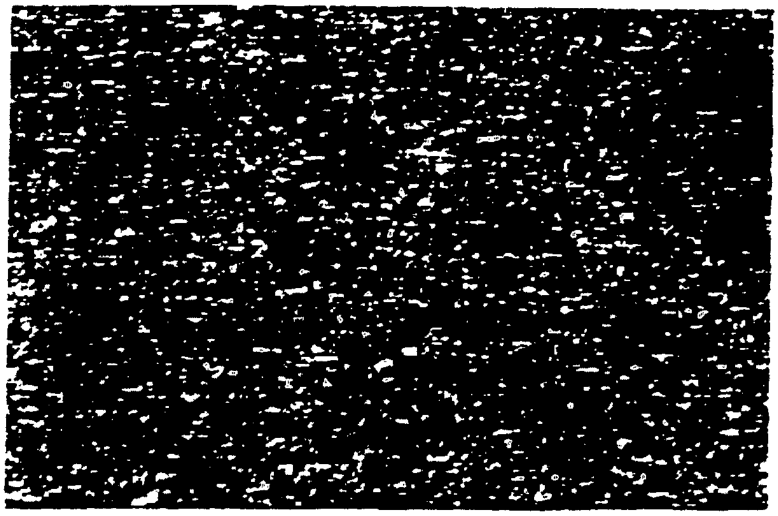

FIG. 1A

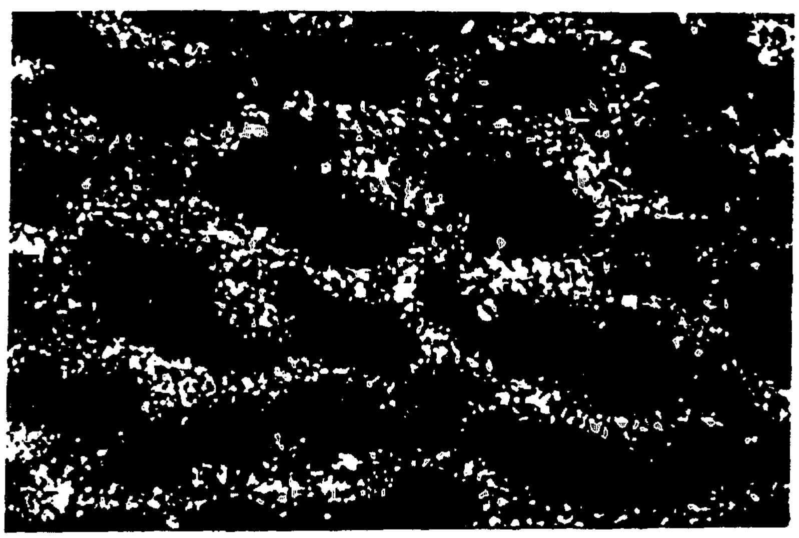

FIG. 1B

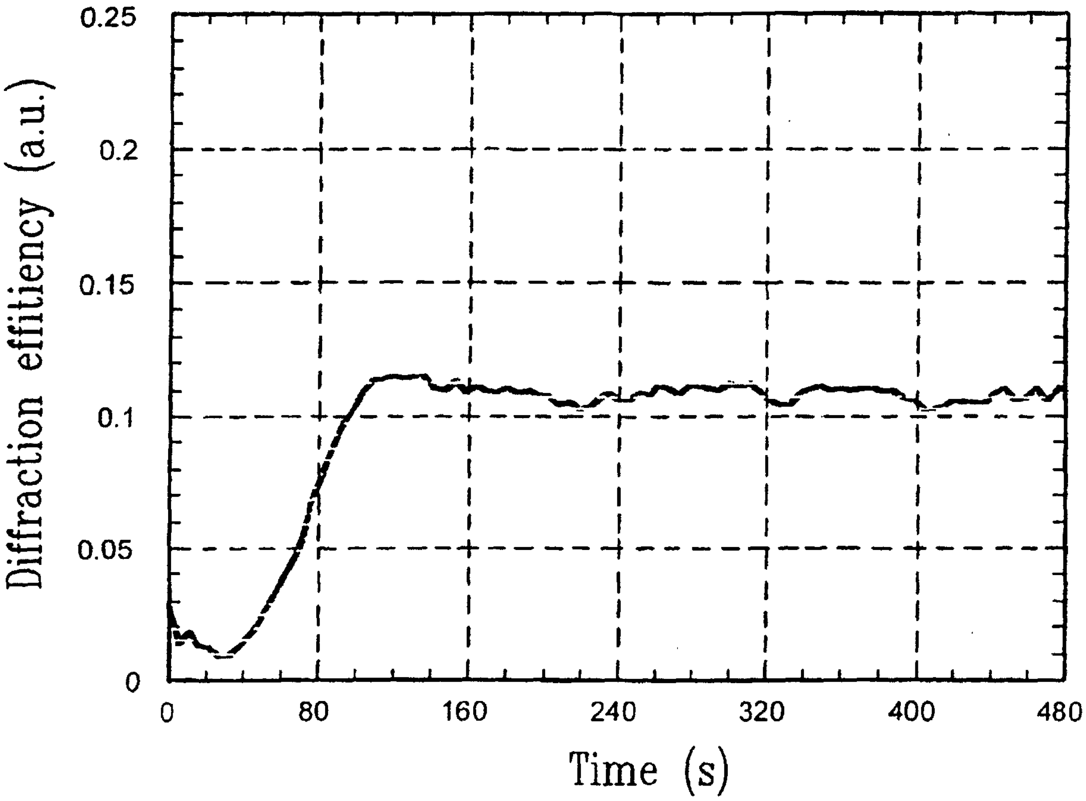
0.25
0.2
0.15
0.1
0.05
0
Diffraction effitiency (a.u.)
0
80
160
240
320
400
480
Time (s)

FIG. 2

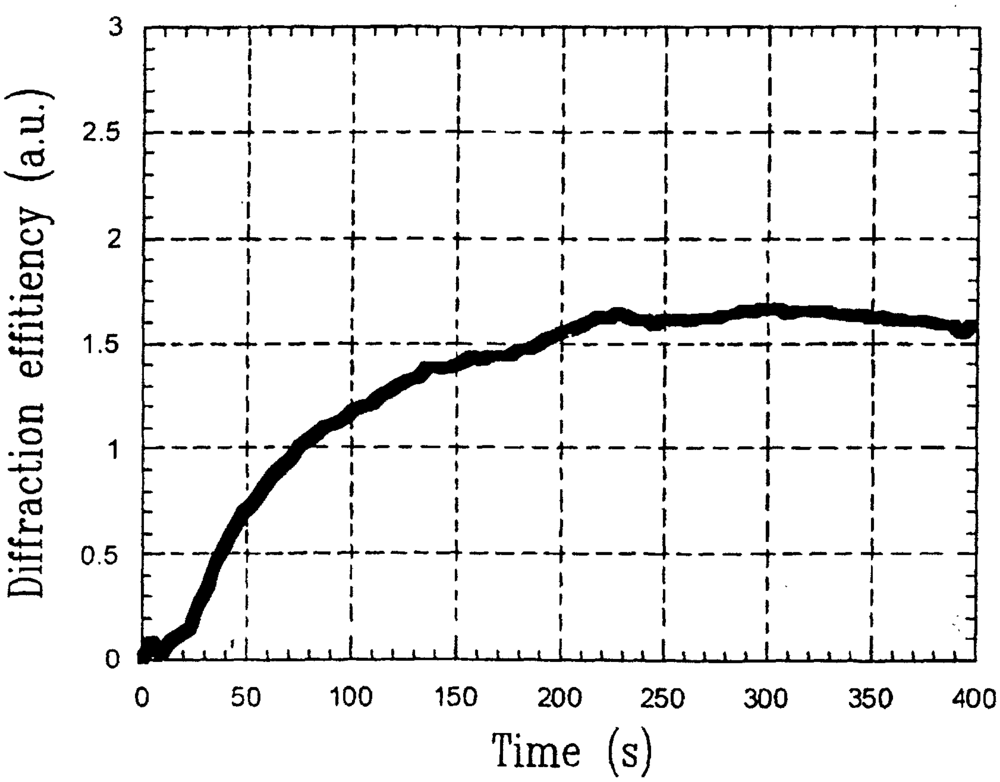
3
2.5
2
1.5
1
0.5
0
Diffraction effitiency (a.u.)
0
50
100
150
200
250
300
350
400
Time (s)

FIG. 3

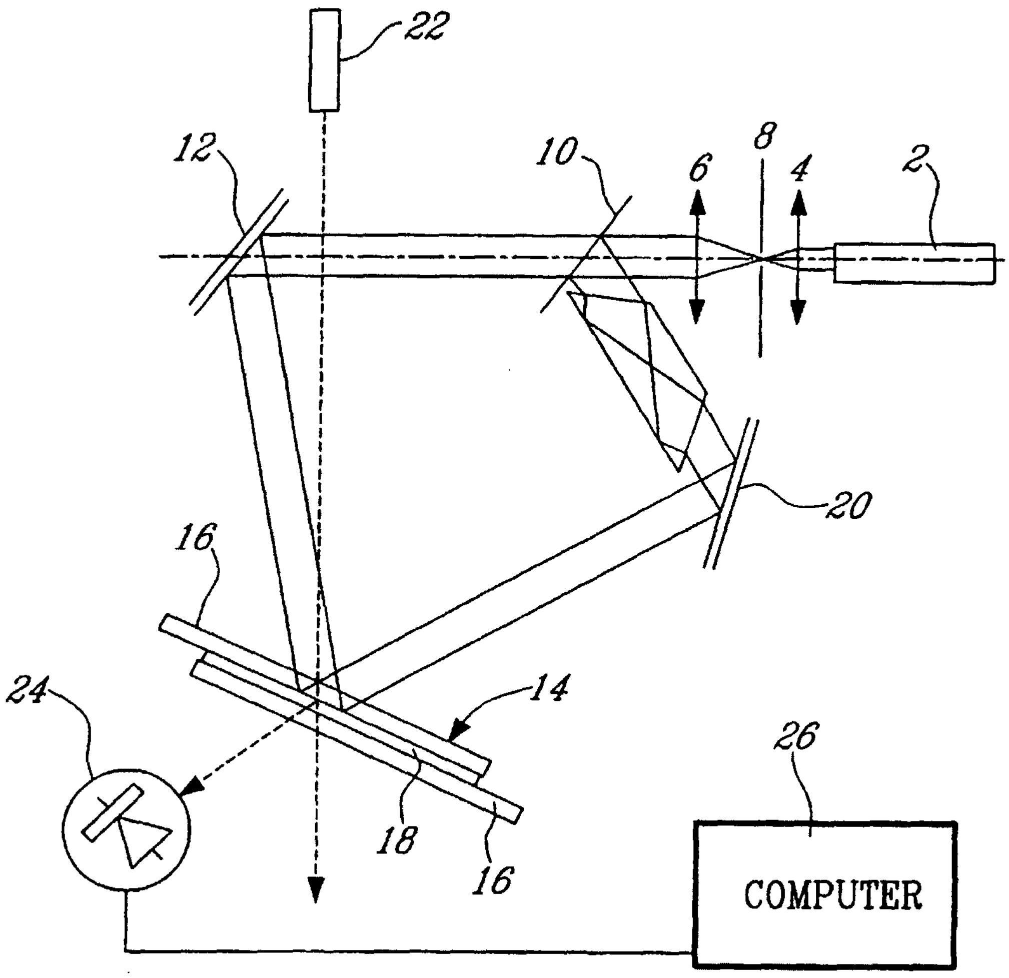


FIG. 4